(19) Europäisches Patentamt
European Patent Office
Office européen des brevets

(11) **EP 4 700 407 A1**

(12) **EUROPEAN PATENT APPLICATION**
published in accordance with Art. 153(4) EPC

(43) Date of publication:
**25.02.2026 Bulletin 2026/09**

(21) Application number: **24937289.7**

(22) Date of filing: **26.12.2024**

(51) International Patent Classification (IPC):
**G01R 31/3835** (2019.01)     **G01R 31/367** (2019.01)
**G01R 19/10** (2006.01)     **G01R 19/165** (2006.01)
**H02J 7/00** (2026.01)

(52) Cooperative Patent Classification (CPC):
**G01R 19/10; G01R 19/165; G01R 31/367;
G01R 31/3835; H02J 7/00**

(86) International application number:
**PCT/KR2024/021108**

(87) International publication number:
**WO 2025/225816 (30.10.2025 Gazette 2025/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.04.2024 KR 20240054637**

(71) Applicant: **LG Energy Solution, Ltd.
Seoul 07335 (KR)**

(72) Inventors:
• **KIM, Minwoo
Daejeon 34122 (KR)**
• **KANG, Sebyeok
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY MANAGEMENT SYSTEM, BATTERY DEVICE, AND METHOD FOR DIAGNOSING CELL VOLTAGE MEASUREMENT LINE**

(57) In a battery management system, a battery monitoring circuit is connected to a battery cell via a cell voltage sensing line, measures a voltage of the battery cell as a first voltage via the cell voltage sensing line while cell balancing of the battery cell is disabled, and measures the voltage of the battery cell as a second voltage via the cell voltage sensing line while the cell balancing of the battery cell is enabled. A processor diagnoses the cell voltage sensing line based on a difference between the first voltage and the second voltage, and the first voltage.

FIG. 4

# EP 4 700 407 A1

**Description**

[Technical Field]

<u>CROSS-REFERENCE TO RELATED APPLICATION</u>

This application claims priority to and the benefit of Korean Patent Application No. 10-2024-0054637 filed in the Korean Intellectual Property Office on April 24, 2024, the entire contents of which are incorporated herein by reference.

The disclosure is directed to a battery management system, a battery apparatus, and a method of diagnosing a cell voltage sensing line.

[Background Art]

An electric vehicle or a hybrid vehicle is a vehicle that obtains power by driving a motor mainly using a battery as a power supply. The electric vehicles are being actively researched because they are alternatives that can solve pollution and energy problems of internal combustion vehicles. Further, batteries are used in various external apparatuses other than the electric vehicles.

Since many battery cells are used as maximum power required by the external apparatus increases, accurate measurement of a voltage of a battery cell (hereinafter referred to as a "cell voltage") is required for accurate diagnosis or control of battery cells. A cell voltage sensing line is used to measure the cell voltage. If the cell voltage sensing line fails, the cell voltage cannot be accurately measured.

If a difference between the cell voltage measured with no balancing current flowing and the cell voltage measured with balancing current flowing is greater than or equal to a predetermined voltage, it may be diagnosed that there is a problem in the cell voltage sensing line. However, when the cell voltage is low, the balancing current is small so that the difference between the two voltages is small. Accordingly, such a method may diagnose the cell voltage sensing line only when the cell voltage is high, and may not diagnose the cell voltage sensing line when the cell voltage is low.

[Disclosure]

[Technical Problem]

Some embodiments may provide a battery management system, a battery apparatus, and a method of diagnosing a cell voltage sensing line that can accurately diagnose the cell voltage sensing line.

[Technical Solution]

According to some embodiments, a battery management system configured to manage a battery cell may be provided. The battery management system may include a battery monitoring circuit connected to the battery cell via a cell voltage sensing line, and configured to measure a voltage of the battery cell as a first voltage via the cell voltage sensing line while cell balancing of the battery cell is disabled, and measure the voltage of the battery cell as a second voltage via the cell voltage sensing line while the cell balancing of the battery cell is enabled, and a processor configured to diagnose the cell voltage sensing line based on a difference between the first voltage and the second voltage, and the first voltage.

A battery apparatus according to some embodiments may include a battery cell, a first cell voltage sensing line connected to a positive electrode of the battery cell, a second cell voltage sensing line connected to a negative electrode of the battery cell, a first resistor connected between the first cell voltage sensing line and a first cell balancing terminal, a switch connected between the first cell balancing terminal and a second cell balancing terminal to which the second cell voltage sensing line is connected, and a processor configured to diagnose the first cell voltage sensing line or the second cell voltage sensing line based on a difference between a first voltage and a second voltage, and the first voltage, the first voltage being a voltage between the first cell voltage sensing line and the second cell voltage sensing line that is measured while the switch is turned off, and the second voltage being a voltage between the first cell voltage sensing line and the second cell voltage sensing line that is measured while the switch is turned on.

According to some embodiments, a method of diagnosing a cell voltage sensing line connected to a battery cell by a battery management system may be provided. The method may include measuring a voltage of the battery cell as a first voltage via the cell voltage sensing line while cell balancing of the battery cell is disabled, measuring the voltage of the battery cell to a second voltage via the cell voltage sensing line while the cell balancing of the battery cell is enable, and diagnosing the cell voltage sensing line based on a difference between the first voltage and the second voltage, and the first voltage.

[Description of the Drawings]

FIG. 1 is a diagram illustrating a battery apparatus according to some embodiments.

FIGS. 2 and 3 are drawings illustrating a method of diagnosing a cell voltage sensing line according to some embodiments.

FIG. 4 is a flowchart illustrating a method of diagnosing a cell voltage sensing line according to some embodiments.

[Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

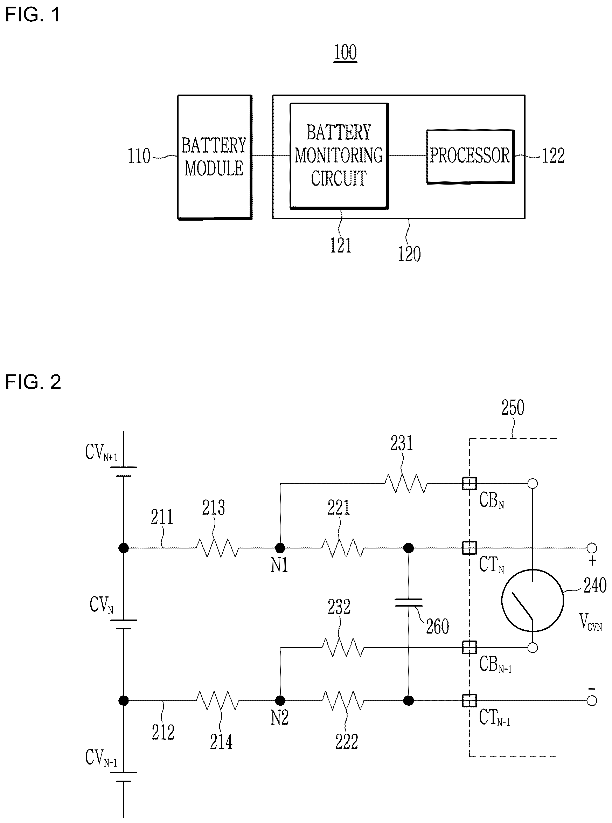

FIG. 1 is a diagram illustrating a battery apparatus according to some embodiments.

Referring to FIG. 1, a battery apparatus 100 may be electrically connected to an external apparatus. In some embodiments, when the external apparatus is a load, the battery apparatus 100 may be discharged by operating as a power supply that supplies power to the load. When the external apparatus is a charger, the battery apparatus 100 may be charged by receiving external power through the charger. In some embodiments, the external apparatus operating as the load may be, for example, an electronic device, a mobility device, or an energy storage system (ESS). The mobility device may be, for example, a vehicle such as an electric vehicle, a hybrid vehicle, or a smart mobility.

The battery apparatus 100 may include a battery module 110 and a battery management system (BMS) 120.

The battery module 110 may include a plurality of battery cells (not shown). In some embodiments, the plurality of battery cells may be connected in series. In some embodiments, a predetermined number of battery modules 110 may be connected in series or parallel to supply desired power. The plurality of battery cells of the battery module 110 may be connected to a battery management system 120 via wires (cell voltage sensing lines), respectively. The battery management system 120 may collect and analyze information about the battery cells to control charging and discharging of the battery cells, cell balancing, an protecting operation, and the like. The battery management system 120 may include a battery monitoring circuit 121 and a processor 122.

The battery monitoring circuit 121 may be connected to the plurality of battery cells included in the battery module 110 via the cell voltage sensing lines, respectively, and monitor states (e.g., cell voltage) of the battery cells. In some embodiments, the battery monitoring circuit 121 may include a plurality of battery monitoring circuits 121 corresponding to the plurality of battery modules 110, respectively. In some embodiments, one battery monitoring circuit 121 may correspond to two or more battery modules 110, or two or more battery monitoring circuit 121 may correspond to one battery module 110. In some embodiments, the battery monitoring circuit 121 may include a battery monitoring integrated circuit (BMIC) provided as an integrated circuit (IC).

The battery monitoring circuit 121 may include a plurality of cell balancing circuits (not shown) corresponding to the plurality of battery cells, respectively. Each cell balancing circuit may perform cell balancing of a corresponding battery cell. The battery monitoring circuit 121 may measure (or sense) a cell voltage of each of the plurality of battery cells. The processor 122 may transfer a control signal to the battery monitoring circuit 121 to control the cell balancing of each battery cell based on the cell voltage of the corresponding battery cell.

The processor 122 may diagnose the cell voltage sensing line through control of cell balancing. While the processor 122 disables the cell balancing, the battery monitoring circuit 121 may measure the cell voltage of the battery cell via the cell voltage sensing line. Further, while the processor 122 enables the cell balancing, the battery monitoring circuit 121 may measure the cell voltage of the battery cell via the cell voltage sensing line. The processor 122 may diagnose the cell voltage sensing line connected to the corresponding battery cell based on the cell voltage measured while the cell balancing is disabled and the cell voltage measured while the cell balancing is enabled. The processor 122 may diagnose that the cell voltage sensing line is abnormal if a ratio of the difference between the cell voltage at the disabled cell balancing and the cell voltage at the enable cell balancing to the cell voltage (e.g., the cell voltage at the disabled cell balancing is disabled) is greater than a threshold ratio.

In some embodiments, the processor 122 may be processing circuitry, for example, a microcontroller unit (MCU).

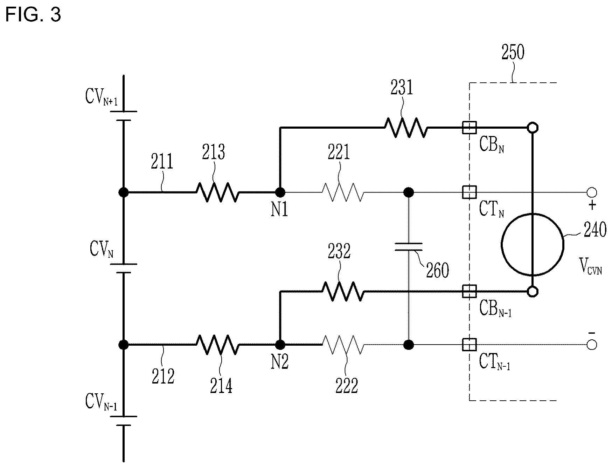

FIGS. 2 and 3 are drawings illustrating a method of diagnosing a cell voltage sensing line according to some embodiments. In FIGS. 2 and 3, one battery cell is shown for convenience.

Referring to FIGS. 2 and 3, cell voltage sensing lines 211 and 212 may be connected to positive and negative electrodes, respectively, for measuring a voltage of a battery cell $CV_N$. The cell voltage sensing line 211 may be a cell voltage sensing line connected to a negative electrode of a battery cell $CV_{N+1}$ adjacent to the battery cell $CV_N$, and the cell voltage sensing line 212 may be a cell voltage sensing line connected to a positive electrode of a battery cell $CV_{N-1}$ adjacent to the battery cell $CV_N$.

The battery management system may include a resistor 221 connected between the cell voltage sensing line 211 and a cell terminal $CT_N$, and a resistor 222 connected between the cell voltage sensing line 212 and a cell terminal $CT_{N-1}$. For example, one end of the cell voltage sensing line 211 may be connected to the positive electrode of the battery cell $CV_N$, the other end (node) N1 of the cell voltage sensing line 211 may be connected to a first terminal of the resistor 221, and a second terminal of the resistor 221 may be connected to the cell terminal $CT_N$. Further, one end of the cell voltage sensing line 212 may be connected to the negative electrode of the battery cell $CV_N$, the other end (node) N2 of the cell voltage sensing line 212 may be connected to a first terminal of the resistor 222, and a second terminal of the resistor 222 may be connected to the cell terminal $CT_{N-1}$.

The battery management system may include a balancing resistor 231 and a balancing switch 240. The balancing resistor 231 may be connected between the cell voltage sensing line 211 and a cell balancing terminal $CB_N$. For example, the balancing resistor 231 may be connected between the second end N1 of the cell voltage sensing line 211 and the cell balancing terminal $CB_N$. The balancing switch 240 may be connected between the cell balancing terminal $CB_N$ and the cell balancing terminal $CB_{N-1}$. The cell balancing terminal $CB_{N-1}$ may be connected to the cell voltage sensing line 212. For example, the cell balancing terminal $CB_{N-1}$ may be connected to the second end N2 of the cell voltage sensing line 212. In some embodiments, a balancing resistor 232 may be connected between the cell voltage sensing line 212 and the cell balancing terminal $CB_{N-1}$. In this case, the balancing resistor 232 may be used for cell balancing of the battery cell $CV_{N-1}$.

In some embodiments, a capacitor 260 may be connected between the cell terminals $CT_N$ and $CT_{N-1}$.

In some embodiments, the cell terminals $CT_N$ and $CT_{N-1}$ and cell balancing terminals $CB_N$ and $CB_{N-1}$ may be pins on a BMIC 250. In this case, the BMIC 250 may include the balancing switch 240 as shown in FIGS. 2 and 3.

In some embodiments, the cell terminals $CT_N$ and $CT_{N-1}$ may be pins on the BMIC 250, and the cell balancing terminals $CB_N$ and $CB_{N-1}$ may be provided separately from the BMIC 250.

Referring to FIG. 2 again, the battery management system may measure a voltage $V_{CVN}$ of the battery cell $CV_N$ while the balancing switch 240 is turned off. Since no current is flowing in the cell voltage sensing lines 211 and 212 due to the turn-off of the balancing switch 240, the measured voltage may be similar to an actual voltage of the battery cell $CV_N$.

Referring to FIG. 3, the battery management system may measure the voltage $V_{CVN}$ of the battery cell $CV_N$ while the balancing switch 240 is turned on. The turn-on of the balancing switch 240 may cause current to flow from the battery cell $CV_N$ through a path of the cell voltage sensing line 211, the resistor 231, the switch 240, the resistor 232, and the cell voltage sensing line 212. Thus, when the battery management system measures the voltage $V_{CVN}$ of the battery cell $CV_N$, a voltage drop may occur due to line resistors 213 and 214 present in the cell voltage sensing lines 211 and 212. If an abnormality exists in the cell voltage sensing line 211 or 212, a resistance of the line resister 213 or 214 may increase, and thus the voltage of the battery cell $CV_N$ may be measured low.

Accordingly, in some embodiments, the battery management system may diagnose that the abnormality exists in the cell voltage sensing line 211 or 212 based on a difference between the voltage $V_{CVN}$(balancing off) measured while the balancing switch 240 is turned off (i.e., the cell balancing is disabled) and the voltage $V_{CVN}$(balancing on) measured while the balancing switch 240 is turned on (i.e., the cell balancing is enabled).

On the other hand, when the voltage of the battery cell $CV_N$ is low, the current flowing through the balancing resistors 231 and 232 is small, so the voltage drop across the line resistors 213 and 214 may be small. In this case, when the abnormality in the cell voltage sensing line 211 or 212 is diagnosed based on only the difference between the voltage $V_{CVN}$(balancing off) measured while the balancing switch 240 is turned off and the voltage $V_{CVN}$(balancing on) measured while the balancing switch 240 is turned on, the difference between the two voltages may be small and the cell voltage sensing lins 211 or 212 may not be diagnosed correctly. Accordingly, in some embodiments, the battery management system may diagnose the abnormality of the cell voltage sensing line 211 or 212 based on the difference between the voltage $V_{CVN}$(balancing off) measured while the balancing switch 240 is turned off and the voltage $V_{CVN}$(balancing on) measured while the balancing switch 240 is turned on, and the voltage of the battery cell $CV_N$. In some embodiments, the voltage $V_{CVN}$(balancing off) measured while the balancing switch 240 is turned off may be used as the voltage of the battery cell $CV_N$.

In some embodiments, the battery management system may diagnose that the abnormality exists in the cell voltage sensing line 211 or 212 when the ratio of the difference between the measured voltage $V_{CVN}$(balancing off) in the state where the balancing switch 240 is turned off and the measured voltage $V_{CVN}$(balancing on) in the state where the balancing switch 240 is turned on to the voltage of the battery cell $CV_N$ is greater than a threshold ratio $V_{ratio}$, as shown in Equation 1. In some embodiments, the threshold ratio $V_{ratio}$ may be set experimentally, for example, 0.02. In other words, if the ratio of the difference between the measured voltage $V_{CVN}$(balancing off) in the state where the balancing switch 240 is turned off and the measured voltage $V_{CVN}$(balancing on) in the state where the balancing switch 240 is turned on to the voltage of the battery cell $CV_N$ is greater than 0.02, it may be diagnosed that there is the abnormality in the cell voltage sensing line 211 or 212 (e.g., the abnormality in the line resistor 213 or 214 of the cell voltage sensing line 211 or 212).

[Equation 1]

$$\frac{|V_{CVN}(\text{balancing off}) - V_{CVN}(\text{balancing on})|}{V_{CVN}(\text{balancing off})} > V_{ratio}$$

As described above, the cell voltage sensing line may be diagnosed by the difference ($|V_{CVN}$(balancing off)-$V_{CVN}$(balancing on)|) of the measured voltages relative to the voltage $V_{CVN}$(balancing off) of the battery cell $CV_N$, so even if the voltage of the battery cell $CV_N$ is low, the abnormality in the cell voltage sensing line may be accurately diagnosed.

In some embodiments, the battery management system may diagnose the abnormality in the cell voltage sensing line for each of the plurality of battery cells.

In some embodiments, a battery monitoring circuit (e.g., 121 in FIG. 1) of the battery management system may measure (i.e., sense) the voltage of the battery cell $CV_N$, and a processor (e.g., 122 in FIG. 1) of the battery management system may diagnose the cell voltage sensing line based on the measured voltage.

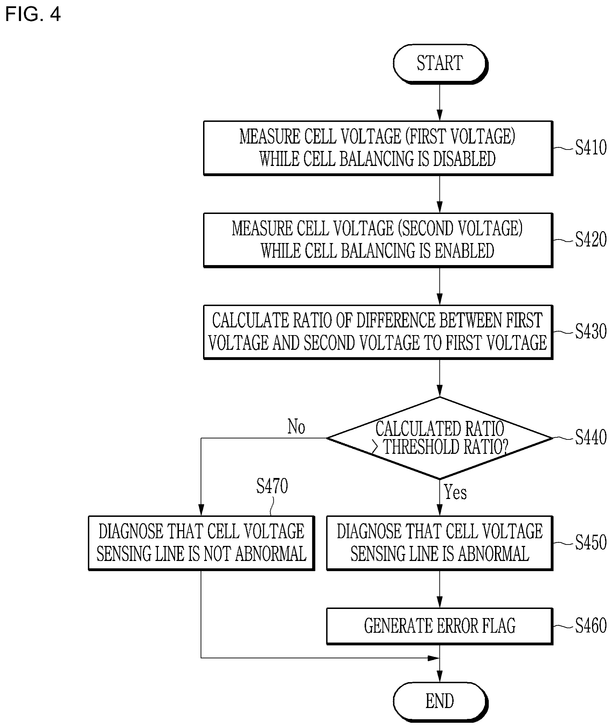

FIG. 4 is a flowchart illustrating a method of diagnosing a cell voltage sensing line according to some embodiments.

Referring to FIG. 4, a battery management system may measure a voltage (first voltage) of a battery cell via a cell voltage sensing line while cell balancing is disabled (S410). The battery management system may measure a voltage (second voltage) of the battery cell via the cell voltage sensing line while the cell balancing is enabled (S420).

The battery management system may calculate a ratio of a difference between the voltage (first voltage) of the battery cell measured while the cell balancing is disabled and the voltage (second voltage) of the battery cell measured while the cell balancing is enabled to the voltage (first voltage) of the battery cell measured while the cell balancing is disabled (S430). The battery management system may compare the calculated ratio to a threshold ratio (S440), and if the calculated ratio is greater than the threshold ratio, the battery management system may diagnose that the cell voltage sensing line is abnormal (S450). In some embodiments, upon diagnosing that the cell voltage sensing line is abnormal, the battery management system may generate an error flag indicating the abnormality of the cell voltage sensing line (S460). In some embodiments, the battery management system may provide the error flag to an external apparatus. Accordingly, the external apparatus (or a user of the external apparatus) may take an action on the cell voltage sensing line. In some embodiments, if the battery management system diagnoses that the cell voltage sensing line is abnormal, the battery management system may shut down the battery management system to prevent a battery apparatus from firing. If the calculated ratio is not greater than the threshold ratio, the battery management system may diagnose that the cell voltage sensing line is not abnormal (S470).

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

**Claims**

1. A battery management system configured to manage a battery cell, the battery management system comprising:

   a battery monitoring circuit connected to the battery cell via a cell voltage sensing line, and configured to measure a voltage of the battery cell as a first voltage via the cell voltage sensing line while cell balancing of the battery cell is disabled, and measure the voltage of the battery cell as a second voltage via the cell voltage sensing line while the cell balancing of the battery cell is enabled; and
   a processor configured to diagnose the cell voltage sensing line based on a difference between the first voltage and the second voltage, and the first voltage.

2. The battery management system of claim 1, wherein the processor is further configured to diagnose an abnormality in the cell voltage sensing line in response to a ratio of the difference between the first voltage and the second voltage to the first voltage exceeding a threshold ratio.

3. The battery management system of claim 2, wherein the processor is further configured to provide an error flag indicating the abnormality in the cell voltage sensing line to an external apparatus to which a battery apparatus comprising the battery management system is connected.

4. The battery management system of claim 1, wherein the cell voltage sensing line comprises a first cell voltage sensing line connected between a positive electrode of the battery cell and a first node, and a second cell voltage sensing line connected between a negative electrode of the battery cell and a second node,

   wherein the battery management system further comprises a first resistor connected between the first node and a first cell balancing terminal, and
   wherein the battery monitoring circuit comprises a switch connected between the first cell balancing terminal and a second cell balancing terminal, disable the cell balancing by turning the switch off, and enable the cell balancing by turning the switch on.

5. The battery management system of claim 4, further comprising a second resistor connected between the second node and the second cell balancing terminal.

6. A battery apparatus comprising:

   a battery cell;
   a first cell voltage sensing line connected to a positive electrode of the battery cell;
   a second cell voltage sensing line connected to a negative electrode of the battery cell;
   a first resistor connected between the first cell voltage sensing line and a first cell balancing terminal;
   a switch connected between the first cell balancing terminal and a second cell balancing terminal to which the second cell voltage sensing line is connected; and
   a processor configured to diagnose the first cell voltage sensing line or the second cell voltage sensing line based on a difference between a first voltage and a second voltage, and the first voltage, the first voltage being a voltage between the first cell voltage sensing line and the second cell voltage sensing line that is measured while the switch is turned off, and the second voltage being a voltage between the first cell voltage sensing line and the second cell voltage sensing line that is measured while the switch is turned on.

7. The battery apparatus of claim 6, wherein the processor is further configured to diagnose that there is an abnormality in the first cell voltage sensing line or the second cell voltage sensing line in response to a ratio of the difference between the first voltage and the second voltage to the first voltage exceeding a threshold ratio.

8. The battery apparatus of claim 7, wherein the processor is further configured to provide an error flag indicating the abnormality in the cell voltage sensing line to an external apparatus to which the battery apparatus is connected.

9. The battery apparatus of claim 7, further comprising a second resistor connected between the second cell voltage sensing line and the second cell balancing terminal.

10. A method of diagnosing a cell voltage sensing line connected to a battery cell by a battery management system, the method comprising:

    measuring a voltage of the battery cell as a first voltage via the cell voltage sensing line while cell balancing of the battery cell is disabled;
    measuring the voltage of the battery cell as a second voltage via the cell voltage sensing line while the cell balancing of the battery cell is enable; and
    diagnosing the cell voltage sensing line based on a difference between the first voltage and the second voltage, and the first voltage.

11. The method of claim 10, wherein diagnosing the cell voltage sensing line comprises diagnosing that the cell voltage sensing line is abnormal in response to a ratio of the difference between the first voltage and the second voltage to the first voltage exceeding a threshold ratio.

FIG. 1

FIG. 2

FIG. 3

FIG. 4

```
                          ( START )
                              │
                              ▼
        ┌──────────────────────────────────────────┐
        │ MEASURE CELL VOLTAGE (FIRST VOLTAGE)      │──── S410
        │ WHILE CELL BALANCING IS DISABLED          │
        └──────────────────────────────────────────┘
                              │
                              ▼
        ┌──────────────────────────────────────────┐
        │ MEASURE CELL VOLTAGE (SECOND VOLTAGE)     │──── S420
        │ WHILE CELL BALANCING IS ENABLED           │
        └──────────────────────────────────────────┘
                              │
                              ▼
        ┌──────────────────────────────────────────┐
        │ CALCULATE RATIO OF DIFFERENCE BETWEEN     │──── S430
        │ FIRST VOLTAGE AND SECOND VOLTAGE TO       │
        │ FIRST VOLTAGE                             │
        └──────────────────────────────────────────┘
                              │
                              ▼
            No         ◇ CALCULATED RATIO       ◇──── S440
        ┌──────────────〈 > THRESHOLD RATIO?     〉
        │                   ◇                    ◇
        │                         │ Yes
S470    │                         ▼
        ▼                 ┌──────────────────────────┐
┌────────────────────┐   │ DIAGNOSE THAT CELL VOLTAGE│──── S450
│ DIAGNOSE THAT CELL │   │ SENSING LINE IS ABNORMAL  │
│ VOLTAGE SENSING    │   └──────────────────────────┘
│ LINE IS NOT        │              │
│ ABNORMAL           │              ▼
└────────────────────┘   ┌──────────────────────────┐
        │                │ GENERATE ERROR FLAG       │──── S460
        │                └──────────────────────────┘
        │                         │
        └────────────┬────────────┘
                     ▼
                 ( END )
```

## INTERNATIONAL SEARCH REPORT

| International application No. |
|---|
| **PCT/KR2024/021108** |

### A. CLASSIFICATION OF SUBJECT MATTER

**G01R 31/3835**(2019.01)i; **G01R 31/367**(2019.01)i; **G01R 19/10**(2006.01)i; **G01R 19/165**(2006.01)i; **H02J 7/00**(2006.01)i

According to International Patent Classification (IPC) or to both national classification and IPC

### B. FIELDS SEARCHED

Minimum documentation searched (classification system followed by classification symbols)

G01R 31/3835(2019.01); B60L 11/18(2006.01); G01R 19/165(2006.01); G01R 31/02(2006.01); G01R 31/36(2006.01); G01R 31/54(2020.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 측정(measure), 밸런싱 회로(balancing circuitry), 스위치(switch), 라인(line), 임계(threshold)

### C. DOCUMENTS CONSIDERED TO BE RELEVANT

| Category* | Citation of document, with indication, where appropriate, of the relevant passages | Relevant to claim No. |
|---|---|---|
| X | CN 106249099 B (BEIJING HYPERSTRONG TECHNOLOGY CO., LTD.) 07 December 2018 (2018-12-07)<br>See paragraphs [0047]-[0066], claims 1-5 and figure 1. | 1,2,4-7,9-11 |
| Y | | 3,8 |
| Y | KR 10-2020-0110615 A (LG CHEM, LTD.) 24 September 2020 (2020-09-24)<br>See paragraph [0066] and figure 1. | 3,8 |
| A | KR 10-2018-0052320 A (HYUNDAI AUTRON CO., LTD.) 18 May 2018 (2018-05-18)<br>See paragraphs [0030]-[0059] and figures 1-4. | 1-11 |
| A | KR 10-2010-0028807 A (LG CHEM, LTD.) 15 March 2010 (2010-03-15)<br>See paragraphs [0039]-[0042] and figure 1. | 1-11 |

☑ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **28 March 2025** | **28 March 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2024/021108** |

| C. | DOCUMENTS CONSIDERED TO BE RELEVANT | |
| --- | --- | --- |
| Category* | Citation of document, with indication, where appropriate, of the relevant passages | Relevant to claim No. |
| A | KR 10-1826645 B1 (HYUNDAI AUTRON CO., LTD.) 07 February 2018 (2018-02-07)<br>See claims 1-6 and figures 1-4. | 1-11 |

Form PCT/ISA/210 (second sheet) (July 2022)

## INTERNATIONAL SEARCH REPORT
### Information on patent family members

International application No.

**PCT/KR2024/021108**

| Patent document cited in search report | | | Publication date (day/month/year) | Patent family member(s) | | | Publication date (day/month/year) |
|---|---|---|---|---|---|---|---|
| CN | 106249099 | B | 07 December 2018 | CN | 106249099 | A | 21 December 2016 |
| KR | 10-2020-0110615 | A | 24 September 2020 | KR | 10-2357373 | B1 | 27 January 2022 |
| | | | | US | 10978751 | B2 | 13 April 2021 |
| | | | | US | 2020-0295407 | A1 | 17 September 2020 |
| KR | 10-2018-0052320 | A | 18 May 2018 | KR | 10-1927123 | B1 | 10 December 2018 |
| KR | 10-2010-0028807 | A | 15 March 2010 | KR | 10-1065562 | B1 | 19 September 2011 |
| KR | 10-1826645 | B1 | 07 February 2018 | | None | | |

Form PCT/ISA/210 (patent family annex) (July 2022)

**REFERENCES CITED IN THE DESCRIPTION**

**Patent documents cited in the description**

- KR 1020240054637